# EUROPEAN PATENT APPLICATION

(11) **EP 4 492 925 A1**
(43) Date of publication of application: **15.01.2025**
(21) Application number: 23784603.5
(22) Date of filing: 15.03.2023
(51) Int. Cl.: H05K 1/02, G01K 1/16, H01L 23/58, H05K 3/46

(54) **SUBSTRATE STRUCTURE AND ELECTRIC COMPRESSOR HAVING SAME**

(30) Priority: 08.04.2022 JP 2022064489
(71) Applicant: MITSUBISHI HEAVY INDUSTRIES THERMAL SYSTEMS, LTD., Tokyo 100-8332 (JP)
(72) Inventor: HATTORI, Makoto, Tokyo 100-8332 (JP); MURASE, Goki, Tokyo 100-8332 (JP); TARUMA, Koshi, Tokyo 100-8332 (JP); HIGUCHI, Hiroto, Tokyo 100-8332 (JP); KOMA, Hirotsugu, Tokyo 100-8332 (JP)
(74) Representative: Cabinet Beau de Loménie
(86) International application number: PCT/JP2023/009987
(87) International publication number: WO 2023/195311

(57) **Abstract**

Provided are a circuit board structure and an electric compressor including the same that can acquire a temperature closer to the true value of a heat element by effectively using a pattern on which the heat element is mounted. An embodiment includes a first layer substrate (110); a second layer substrate (120) stacked on the first layer substrate (110); an electronic component (210) mounted on a first layer pattern (112) and a second layer pattern (122); and a temperature sensor (220) mounted on the first layer substrate (110) at a position not in contact with and adjacent to the electronic component (210) and configured to acquire a temperature of the electronic component (210). The second layer pattern (122) includes a second layer main pattern part (122a) overlapping with the electronic component (210) when planarly viewed, the electronic component (210) being mounted thereon, and a second layer expanded pattern part (122b) formed to overlap with the temperature sensor (220) when planarly viewed and connected to the second layer main pattern part (122a).

## Description

### [Technical Field]

The present disclosure relates to a circuit board structure and an electric compressor including the same.

### [Background Art]

On some circuit boards used for controlling driving of electric compressors, electronic components that may be heat elements are mounted. To acquire temperatures of such electronic components, temperature sensors are conventionally installed near the electronic components on the circuit boards.

Further, for example, Patent Literature 1 discloses a structure that transfers heat of an FET element to a thermistor element via a through-hole and a metal wiring layer.

### [Citation List]

### [Patent Literature]

[PTL 1]
Japanese Patent Application Laid-Open No. 2014-116329

### [Summary of Invention]

### [Technical Problem]

However, the structure of Patent Literature 1 is used in a metal wiring layer connecting two FET elements to each other to transfer the heat of the FET elements to the thermistor element and may involve constraints in the design of the metal wiring layer.

The present disclosure has been made in view of such circumstances and intends to provide a circuit board structure and an electric compressor including the same that can acquire a temperature closer to the true value of a heat element by effectively using a pattern on which the heat element is mounted.

### [Solution to Problem]

To solve the above problem, the circuit board structure and the electric compressor including the same of the present disclosure employ the following solutions.

The circuit board structure according to one aspect of the present disclosure includes: a first layer substrate including a first insulating layer and a first layer pattern formed on a front side of the first insulating layer; a second layer substrate including a second insulating layer and a second layer pattern formed on a front side of the second insulating layer, the second layer substrate being stacked on the first layer substrate such that the second layer pattern is located on a backside of the first insulating layer; a heat element mounted on the first layer pattern and the second layer pattern; and a temperature acquisition unit mounted on the first layer substrate at a position not in contact with and adjacent to the heat element and configured to acquire a temperature of the heat element, and the second layer pattern has a second layer main pattern part overlapping with the heat element when planarly viewed in a laminating direction of the first layer substrate and the second layer substrate, the heat element being mounted on the second layer main pattern part, and a second layer expanded pattern part formed so as to overlap with the temperature acquisition unit when planarly viewed in the laminating direction and connected to the second layer main pattern part.

Further, the electric compressor according to one aspect of the present disclosure includes the circuit board structure described above.

### [Advantageous Effects of Invention]

According to the present disclosure, a temperature closer to the true value of a heat element can be acquired by effectively using a pattern on which the heat element is mounted.

### [Brief Description of Drawings]

[Fig. 1]

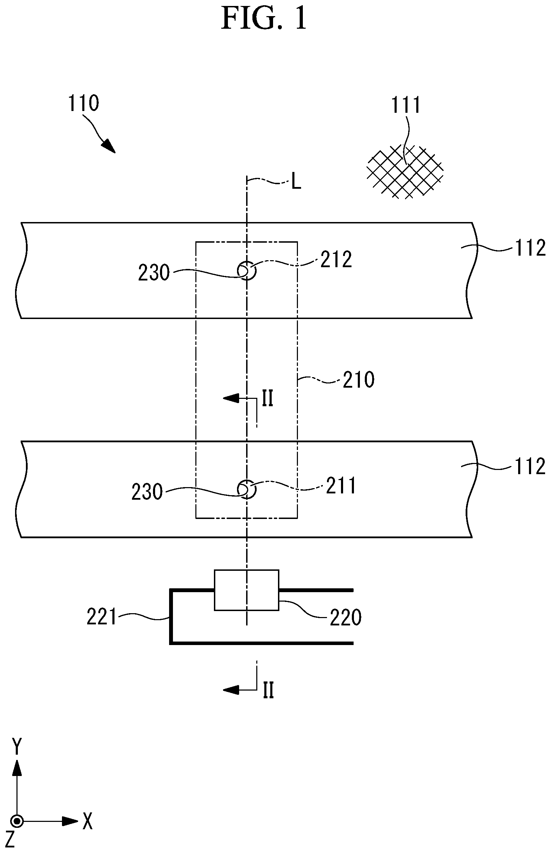

   Fig. 1 is a plan view of a first layer substrate of a circuit board structure according to one embodiment of the present disclosure.
[Fig. 2]

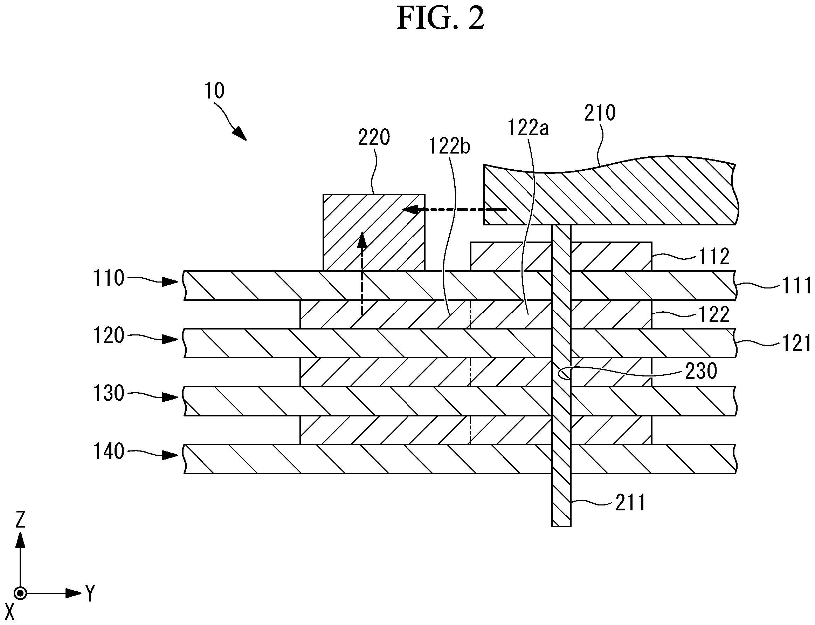

   Fig. 2 is a longitudinal sectional view taken along the cutting line II-II illustrated in Fig. 1.
[Fig. 3]

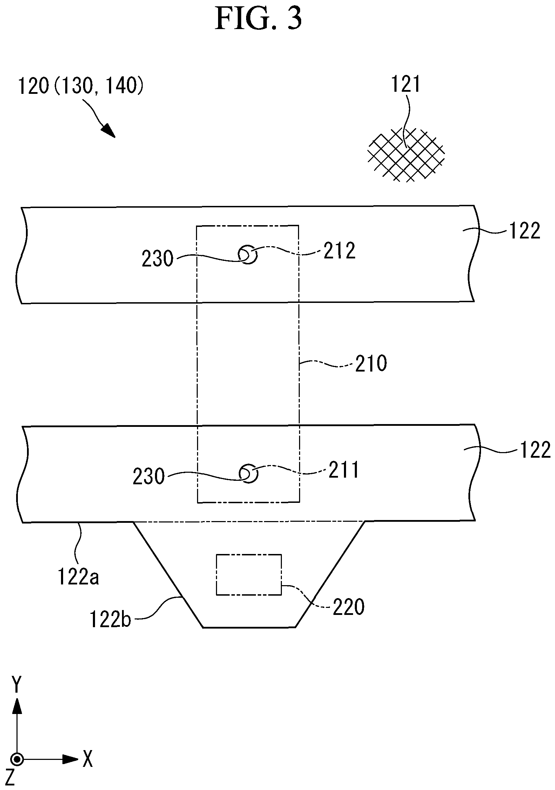

   Fig. 3 is a plan view of a second layer substrate, a third layer substrate, or a fourth layer substrate of the circuit board structure according to one embodiment of the present disclosure.
[Fig. 4]

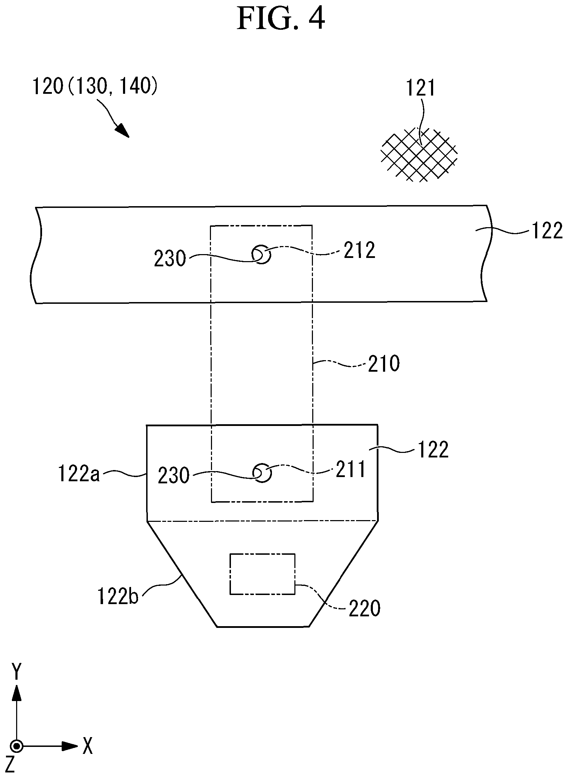

   Fig. 4 is a plan view of a second layer substrate, a third layer substrate, or a fourth layer substrate according to another example of the circuit board structure according to one embodiment of the present disclosure.
[Fig. 5]

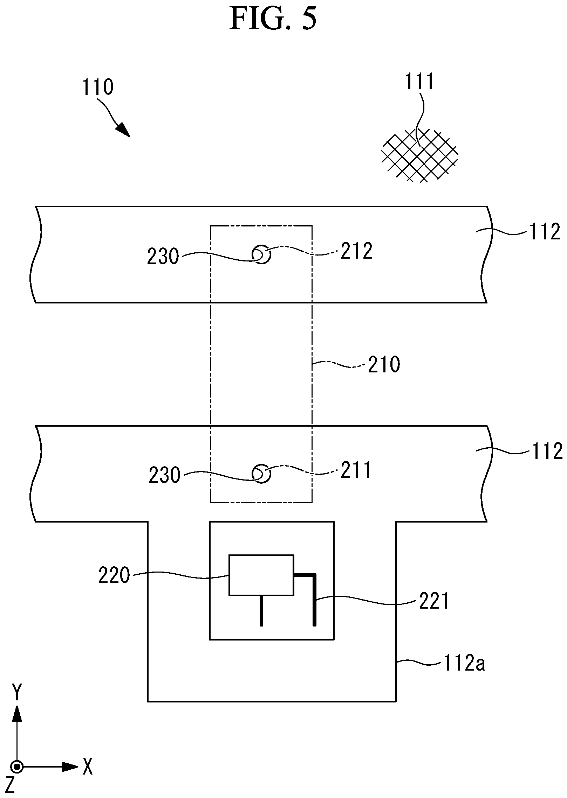

   Fig. 5 is a plan view of a first layer substrate according to a modified example of the circuit board structure according one embodiment of the present disclosure.
[Fig. 6]

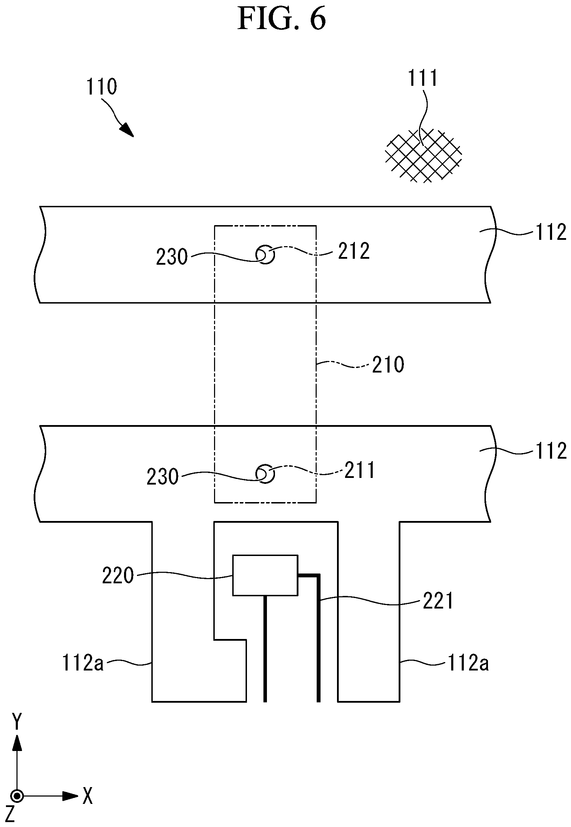

   Fig. 6 is a plan view of a first layer substrate according to a modified example of the circuit board structure according one embodiment of the present disclosure.

### [Description of Embodiments]

A circuit board structure and an electric compressor including the same according to one embodiment of the present disclosure will be described below with reference to the drawings.

A circuit board structure 10 is a part of an electronic device forming a control unit used for controlling driving of an electric compressor. Thus, the circuit board structure 10 is provided in the electric compressor.

As illustrated in Fig. 1 and Fig. 2, the circuit board structure 10 is formed of a plurality of substrates laminated in the Z-axis direction and includes, for example, a first layer substrate 110 and a second layer substrate 120. Note that the number of substrates to be laminated can be changed as appropriate in accordance with the specification.

Further, an electronic component 210 and a temperature sensor 220 are arranged on the front side (the top face in the Z-axis direction in Fig. 2) of the first layer substrate 110.

The electronic component 210 is a component that is electrically connected to patterns of each substrate described later and generates heat when current is supplied thereto. An example of the electronic component 210 may be a capacitor.

The temperature sensor 220 is a sensor that acquires the temperature of the electronic component 210 and is arranged adjacent to the electronic component 210. The expression of an object being "adjacent to" as used herein means a state where the object is not in contact with the electronic component 210 and is arranged near the electronic component 210 while maintaining a distance that can ensure electrical insulation between the object and the electronic component 210 or a first layer pattern 112 described later. An example of the temperature sensor 220 may be a thermistor.

The first layer substrate 110 has a first insulating layer 111 and first layer patterns 112.

The first insulating layer 111 is a plate-like insulating component.

Each first layer pattern 112 is a circuit with a conductor foil (for example, a copper foil) formed on the front side of the first insulating layer 111. In the case of Fig. 1, two first layer patterns 112 are represented, and each first layer pattern has a width in the X direction and extends in the Y direction.

As illustrated in Fig. 2, the second layer substrate 120 is a substrate stacked on the backside (the bottom face in the Z-axis direction in Fig. 2) of the first layer substrate 110.

As illustrated in Fig. 2 and Fig. 3, the second layer substrate 120 has a second insulating layer 121 and second layer patterns 122.

The second insulating layer 121 is a plate-like insulating component.

Each second layer pattern 122 is a circuit with a conductor foil (for example, a copper foil) formed on the front side of the second insulating layer 121. In the case of Fig. 3, two second layer patterns 122 are represented, and each second layer pattern has a width in the Y direction and extends in the X direction. The second layer patterns 122 are located on the backside of the first insulating layer 111 in a state where the second layer substrate 120 is stacked on the first layer substrate 110.

One second layer pattern 122 of the two second layer patterns 122 has a second layer main pattern part 122a and a second layer expanded pattern part 122b.

The second layer main pattern part 122a is a portion having a width in the Y direction and extending in the X direction in the same manner as the other second layer pattern 122 and the first layer main pattern.

The second layer expanded pattern part 122b is a portion formed so as to protrude from the edge along the Y direction of the second layer main pattern part 122a. Thus, it can be said that the second layer expanded pattern part 122b is a partially expanded portion of the edge along the Y direction of the second layer main pattern part 122a. Herein, the second layer expanded pattern part 122b is electrically/thermally connected to the second layer main pattern part 122a.

Note that, in Fig. 2 and Fig. 3, boundaries illustrated by two-dot chain lines are depicted between the second layer main pattern part 122a and the second layer expanded pattern part 122b, but these boundaries are virtual lines for illustration. Further, in the case illustrated in Fig. 3, the second layer expanded pattern part 122b is formed so as to have a smaller area than the second layer main pattern part 122a.

A lead terminal 211 and a lead terminal 212 of the electronic component 210 are electrically connected to the first layer patterns 112 and the second layer patterns 122 (the second layer main pattern part 122a) described above. Thus, the electronic component 210 is mounted on the first layer pattern 112 and the second layer pattern 122. For example, the lead terminal 211 and the lead terminal 212 are inserted through and mounted on respective through-holes 230 penetrating through the first layer substrate 110 including the first layer patterns 112 and the second layer substrate 120 including the second layer patterns 122.

Note that any one of the lead terminal 211 and the lead terminal 212 is the plus terminal, and the other is the minus terminal.

Further, it is apparent that the first layer pattern 112 and the second layer pattern 122 electrically connected to the plus terminal of the electronic component 210 are the plus patterns, and the first layer pattern 112 and the second layer pattern 122 electrically connected to the minus terminal of the electronic component 210 are the minus patterns.

In the above configuration, as illustrated in Fig. 2 and Fig. 3, the second layer main pattern part 122a is at a position overlapping with the electronic component 210 in the XY direction when planarly viewed in the Z-axis direction.

This is natural in view of the lead terminal 211 of the electronic component 210 being connected to the second layer main pattern part 122a.

On the other hand, the second layer expanded pattern part 122b is at a position overlapping with the temperature sensor 220 in the XY direction when planarly viewed in the Z-axis direction. Thus, the temperature sensor 220 is located right above in the Z-axis direction of the second layer expanded pattern part 122b. In other words, the second layer expanded pattern part 122b can be formed so as to include the region right under in the Z-axis direction of the temperature sensor 220. In yet other words, the second layer expanded pattern part 122b can be formed by partially expanding the edge (contour) of the second layer main pattern part to surround the temperature sensor 220 when planarly viewed in the Z-axis direction.

Note that the second layer expanded pattern part 122b may be formed as illustrated in Fig. 4.

The second layer expanded pattern part 122b formed as described above functions as follows.

As illustrated in Fig. 2, first, the heat of the electronic component 210 is transferred to the second layer main pattern part 122a located right under in the Z-axis direction of the electronic component 210.

Note that the heat is transferred via the first layer pattern 112, the first insulating layer 111, the lead terminal 211, and the through-hole 230.

Next, the heat is transferred to the second layer expanded pattern part 122b electrically/thermally connected to the second layer main pattern part 122a.

The heat is then transferred to the temperature sensor 220 located right above in the Z-axis direction of the second layer expanded pattern part 122b.

Note that the heat is transferred via the first insulating layer 111.

This makes it possible to realize heat transfer in the Z-axis direction by heat conduction via the second layer pattern 122 (see the dashed line arrow illustrated in Fig. 2) in addition to heat transfer in the XY direction mainly by radiation above the first layer substrate 110 (see the two-dot chain line arrow illustrated in Fig. 2).

Note that it is sufficient that the temperature sensor 220 is at least arranged near the electronic component 210, but it is preferable to arrange the temperature sensor 220 on the straight line L passing through the two through-holes 230 as illustrated in Fig. 1 in terms of efficiently receiving the heat of the electronic component 210 by radiation.

Further, as with the third layer substrate 130 and the fourth layer substrate 140 illustrated in Fig. 2, the n-th layer substrate having the same structure as the second layer substrate 120 may be laminated. Herein, n is an integer of three or greater, and the n-th layer substrate is stacked on the backside of the (n-1)-th layer substrate.

Further, electronic components 210 may be installed at multiple positions on the front side of the first layer substrate 110.

Further, the expanded pattern part is not necessarily required to be formed on the substrates subsequent to the third layer substrate 130.

According to the present embodiment, the following effects and advantages are achieved.

The second layer pattern 122 has the second layer main pattern part 122a overlapping with the electronic component 210 when planarly viewed in the Z-axis direction and the second layer expanded pattern part 122b formed so as to overlap with the temperature sensor 220 when planarly viewed in the Z-axis direction and connected to the second layer main pattern part 122a. Thus, the temperature sensor 220 can acquire the temperature by radiation from the adjacent electronic component 210 and by heat conduction via the second layer expanded pattern part 122b located right under the temperature sensor 220.

Accordingly, the temperature closer to the true value can be acquired compared to a case where the temperature is acquired mainly by radiation from the electronic component 210.

Further, the first layer pattern 112 and the second layer main pattern part 122a are connected to each other via the lead terminal 211 of the electronic component 210, and thus heat can be efficiently transferred from the first layer pattern 112, which is heated by the electronic component 210, to the second layer main pattern part 122a.

Further, the temperature sensor 220 is arranged on the straight line L passing through the two through-holes 230, and thus the temperature sensor 220 can be arranged at a position near the electronic component 210.

Accordingly, heat can be efficiently transferred from the electronic component 210 to the temperature sensor 220 by radiation.

### [Modified Example]

As illustrated in Fig. 5, in the first layer substrate 110, the first layer pattern 112 may have a surrounding pattern part 112a.

The surrounding pattern part 112a is a path using a conductor foil (for example, a copper foil) formed on the front side of the first insulating layer 111 and is formed so as to entirely surround the temperature sensor 220 in the XY direction.

In such a case, the wiring patterns 221 functioning as the power line and the signal line of the temperature sensor 220 extend in the Z-axis direction via other through-holes or the like so that the wiring patterns 221 are not in contact with the surrounding pattern part 112a.

Note that the surrounding pattern part 112a may be formed so as to partially surround the temperature sensor 220 in the XY direction without entirely surrounding the temperature sensor 220 as illustrated in Fig. 6.

With such a configuration, heat can be efficiently transferred from the first layer pattern 112, which is heated by the electronic component 210, to the temperature sensor 220 via the surrounding pattern part 112a.

One embodiment described above is understood as follows, for example.

The circuit board structure (10) according to a first aspect of the present disclosure includes: a first layer substrate (110) including a first insulating layer (111) and a first layer pattern (112) formed on the front side of the first insulating layer; a second layer substrate (120) including a second insulating layer (121) and a second layer pattern (122) formed on the front side of the second insulating layer, the second layer substrate being stacked on the first layer substrate such that the second layer pattern is located on the backside of the first insulating layer; a heat element (210) mounted on the first layer pattern and the second layer pattern; and a temperature acquisition unit (220) mounted on the first layer substrate at a position not in contact with and adjacent to the heat element and configured to acquire the temperature of the heat element, and the second layer pattern has a second layer main pattern part (122a) overlapping with the heat element when planarly viewed in a laminating direction of the first layer substrate and the second layer substrate, the heat element being mounted on the second layer main pattern part, and a second layer expanded pattern part (122b) formed so as to overlap with the temperature acquisition unit when planarly viewed in the laminating direction and connected to the second layer main pattern part.

The circuit board structure includes: the first layer substrate; the second layer substrate stacked on the first layer substrate; the heat element mounted on the first layer pattern and the second layer pattern; and the temperature acquisition unit mounted on the first layer substrate at a position not in contact with and adjacent to the heat element and configured to acquire the temperature of the heat element, and the second layer pattern has the second layer main pattern part overlapping with the heat element when planarly viewed in a laminating direction of the first layer substrate and the second layer substrate and has the second layer expanded pattern part formed so as to overlap with the temperature acquisition unit when planarly viewed in the laminating direction and connected to the second layer main pattern part. Thus, the temperature acquisition unit can acquire the temperature by radiation from the adjacent heat element and by heat conduction via the second layer expanded pattern part of the second layer pattern located right under the temperature acquisition unit (in detail, also via the first insulating layer).

Accordingly, the temperature closer to the true value can be acquired compared to a case where the temperature is acquired mainly by radiation from the heat element.

An example of the heat element may be an electronic component such as a capacitor.

An example of the temperature acquisition unit may be a temperature sensor such as a thermistor.

Further, for the circuit board structure according toa second aspect of the present disclosure, which is dependent on the first aspect, the first layer pattern and the second layer main pattern part are connected to each other via a lead terminal (211) of the heat element.

According to the circuit board structure of the present aspect, the first layer pattern and the second layer main pattern part are connected to each other via the lead terminal of the heat element, and thus heat can be efficiently transferred from the first layer pattern, which is heated by the heat element, to the second layer main pattern part.

Further, for the circuit board structure according to a third aspect of the present disclosure, which is dependent on the first aspect or the second aspect, the first layer substrate has two through-holes (230) penetrating through the first layer pattern, and the temperature acquisition unit is arranged on a straight line (L) passing through the two through-holes.

According to the circuit board structure of the present aspect, the first layer substrate has two through-holes penetrating through the first layer pattern, and the temperature acquisition unit is arranged on a straight line passing through the two through-holes. Thus, the temperature acquisition unit can be arranged at a position near the heat element.

Accordingly, heat can be efficiently transferred from the heat element to the temperature acquisition unit by radiation.

Further, for the circuit board structure according to a fourth aspect of the present disclosure, which is dependent on any one of the first aspect to the third aspect, when the circuit board structure includes an (n-1)-th layer substrate having an (n-1)-th insulating layer and an (n-1)-th layer pattern formed on the front side of the (n-1)-th insulating layer, the (n-1)-th layer substrate being stacked on an (n-2)-th layer substrate such that the (n-1)-th layer pattern is located on the backside of an (n-2)-th insulating layer, and where n is an integer of three or greater, the circuit board structure includes an n-th layer substrate having an n-th insulating layer and an n-th layer pattern formed on the front side of the n-th insulating layer, the n-th layer substrate being stacked on the (n-1)-th layer substrate such that the n-th layer pattern is located on the backside of the (n-1)-th insulating layer, the heat element is also mounted on the n-th layer pattern, and the n-th layer pattern has an n-th layer main pattern part overlapping with the heat element when planarly viewed in a laminating direction, the heat element being mounted on the n-th layer main pattern part, and an n-th layer expanded pattern part formed so as to overlap with the temperature acquisition unit when planarly viewed in the laminating direction and connected to the n-th layer main pattern part.

According to the circuit board structure of the present aspect, the n-th layer pattern has the n-th layer expanded pattern part. Thus, even when the third layer substrate (130), the fourth layer substrate (140), ... are stacked on the second layer substrate, the temperature acquisition unit can acquire the temperature by heat conduction via each expanded pattern part.

Further, for the circuit board structure according to a fifth aspect of the present disclosure, which is dependent on any one of the first aspect to the fourth aspect, the first layer pattern has a surrounding pattern part (112a) surrounding the temperature acquisition unit when planarly viewed in the laminating direction.

According to the circuit board structure of the present aspect, the first layer pattern has a surrounding pattern part surrounding the temperature acquisition unit when planarly viewed in the laminating direction, and thus heat can be efficiently transferred from the first layer pattern, which is heated by the heat element, to the temperature acquisition unit via the surrounding pattern part.

Further, the electric compressor according to a sixth aspect of the present disclosure includes the circuit board structure according to any one of the first aspect to the fifth aspect.

### [Reference Signs List]

10 circuit board structure
110 first layer substrate
111 first insulating layer
112 first layer pattern
112a surrounding pattern part
120 second layer substrate
121 second insulating layer
122 second layer pattern
122a second layer main pattern part
122b second layer expanded pattern part
130 third layer substrate
140 fourth layer substrate
210 electronic component (heat element)
211 lead terminal
212 lead terminal
220 temperature sensor (temperature acquisition unit)
221 wiring pattern
230 through-hole

## Claims

1. A circuit board structure comprising:
a first layer substrate including a first insulating layer and a first layer pattern formed on a front side of the first insulating layer;
a second layer substrate including a second insulating layer and a second layer pattern formed on a front side of the second insulating layer, the second layer substrate being stacked on the first layer substrate such that the second layer pattern is located on a backside of the first insulating layer;
a heat element mounted on the first layer pattern and the second layer pattern; and
a temperature acquisition unit mounted on the first layer substrate at a position not in contact with and adjacent to the heat element and configured to acquire a temperature of the heat element,
wherein the second layer pattern includes
a second layer main pattern part overlapping with the heat element when planarly viewed in a laminating direction of the first layer substrate and the second layer substrate, the heat element being mounted on the second layer main pattern part, and
a second layer expanded pattern part formed so as to overlap with the temperature acquisition unit when planarly viewed in the laminating direction and connected to the second layer main pattern part.

2. The circuit board structure according to claim 1, wherein the first layer pattern and the second layer main pattern part are connected to each other via a lead terminal of the heat element.

3. The circuit board structure according to claim 1 or 2,
wherein the first layer substrate includes two through-holes penetrating through the first layer pattern, and
wherein the temperature acquisition unit is arranged on a straight line passing through the two through-holes.

4. The circuit board structure according to claim 1 or 2, wherein
when the circuit board structure comprises an (n-1)-th layer substrate including an (n-1)-th insulating layer and an (n-1)-th layer pattern formed on a front side of the (n-1)-th insulating layer, the (n-1)-th layer substrate being stacked on an (n-2)-th layer substrate such that the (n-1)-th layer pattern is located on a backside of an (n-2)-th insulating layer, and where n is an integer of three or greater,
the circuit board further comprises an n-th layer substrate including an n-th insulating layer and an n-th layer pattern formed on a front side of the n-th insulating layer, the n-th layer substrate being stacked on the (n-1)-th layer substrate such that the n-th layer pattern is located on a backside of the (n-1)-th insulating layer,
the heat element is also mounted on the n-th layer pattern, and
the n-th layer pattern includes
an n-th layer main pattern part overlapping with the heat element when planarly viewed in the laminating direction, the heat element being mounted on the n-th layer main pattern part, and
an n-th layer expanded pattern part formed so as to overlap with the temperature acquisition unit when planarly viewed in the laminating direction and connected to the n-th layer main pattern part.

5. The circuit board structure according to claim 1 or 2, wherein the first layer pattern includes a surrounding pattern part surrounding the temperature acquisition unit when planarly viewed in the laminating direction.

6. An electric compressor comprising the circuit board structure according to claim 1 or 2.
